# EUROPEAN PATENT SPECIFICATION

(11) **EP 2 369 224 B1**
(45) Date of publication and mention of the grant of the patent: **09.05.2012**
(21) Application number: 10197079.6
(22) Date of filing: 27.12.2010
(51) Int. Cl.: F21S 8/00, F21V 5/00, F21V 7/00, F21V 19/02, F21V 3/04, F21V 7/22, F21V 31/04, F21W 131/406, F21Y 101/02

(54) **LED light projector with single reflected beam**
LED-Scheinwerfer mit einem einzelnen reflektierten Strahl
Projecteur à DEL avec un seul faisceau réflecté

(30) Priority: 23.03.2010 IT PR20100021
(43) Date of publication of application: 28.09.2011
(73) Proprietor: COEMAR S.p.A., 46042 Castel Goffredo (MN) (IT)
(72) Inventor: Allegri, Fabio, 46042, Castel Goffredo (MN) (IT)
(74) Representative: Gotra, Stefano

(56) References cited:
- EP-A2- 2 177 816
- WO-A1-2008/050783
- DE-A1-102008 006 249
- JP-A- 2005 100 723
- US-A1- 2009 103 293

## Description

The present invention relates to a LED light projector, in particular for use in the sector of show business.

As is known, the market already offers various types of projectors using LED light sources. One of the most common solutions includes electronic mixing (using software programs) of light beams emanating from a plurality of white LED sources, or LED sources of other colours mounted on a support.

The main disadvantage of this solution is that even if the mixing is a good and accurate one, when frontally observing the projector the observer perceives a collection of points of different colours, each corresponding to one of the sources forming the projector. In practice, the illumination becomes homogeneous only at a certain distance from the projector, but there is a not-insignificant tract in which the different coloured light beams giving rise to the final mixed beam are distinguishable.

There also exists the possibility of obtaining a better homogenisation by predisposing small groups of LED sources under a single lens or a single optical element (see patent application PR2008A000029 filed by the same applicant). However, it is not possible to predispose all the LED sources of a large-dimension projector under a single optical element. Therefore, in this case too, there remains the problem of dishomogeneity in the beam when viewed frontally.

Among other things, many of these solutions, in order to reach high levels of power, must be excessively large.

A further disadvantage of the known solutions lies in the fact that in order to modify the aperture of the mixed cone rather complex optics are required, which however do not solve the problem of the frontal perception of a plurality of beams.

In this context, the technical task at the basis of the present invention is to provide a LED light projector which obviates the drawbacks in the above-cited prior art.

In particular, an aim of the present invention is to make available a LED light projector able to uniformly mix the light beams emitted by the single LED sources, such that an observer located frontally of the projector perceives a homogeneous illumination.

A further aim of the present invention is to provide a LED light projector in which the aperture of the light cone emitted is easily modifiable.

A further aim of the present invention is to provide a LED light projector having smaller dimensions with respect to the solutions in the prior art.

The defined technical task and the set aims are substantially attained by a LED light projector, comprising the technical characteristics set out in one or more of the appended claims.

Patent application US 2009/103293 shows a LED illumination device using LED light sources within a light mixing cavity according to the preamble of claim 1.

Further characteristics and advantages of the present invention will emerge more clearly from the indicative and therefore non-limiting description, of a preferred but not exclusive embodiment of a LED light projector, as illustrated in the accompanying drawings, in which:
- figures 1 and 2 illustrate a LED light projector, in a simplified schematic view;
- figure 3 illustrates a detail (box-like body) of the LED light projector, in a first embodiment, in a lateral section view;
- figure 4 illustrates the detail of figure 3, in a second embodiment, in a lateral section view.

With reference to the figures, 1 denotes a LED light projector, in particular to be used in the show business sector. The projector 1 comprises a plurality of LED light sources 3, capable of emitting a corresponding number of light beams 4. The projector 1 is further provided with means 17 for mixing the light beams 4 originating from the sources 3 in such a way as to obtain a single beam 14. The means 17 comprise an optical element 8 located opposite the light sources 3. Originally, the optical element 8 is a frosted optical lens. In particular, the frosted optical lens 8 is obtained from an assembly of optical micro-lenses.

A reflecting surface 2 is set at a pre-established distance d from the optical lens 8 so that said single beam 14 strikes the reflecting surface 2, giving rise by reflection to a homogeneous light cone 6. The reflecting surface 2 is preferably parabolic or spherical. The pre-established distance d is variable so as to modify the aperture of the light cone 6.

The projector 1 comprises a box-like body 7 internally housing the light sources 3. The box-like body 7 advantageously has interior walls 7a that are white-painted, which form part of the means 17 for mixing the light beams 4 issued by the sources 3. The interior walls 7a are preferably coated with compounds based on calcium carbonate or magnesium carbonate in order to achieve a high diffusion power. Alternatively, the interior walls 7a are coated with titanium-based compounds.

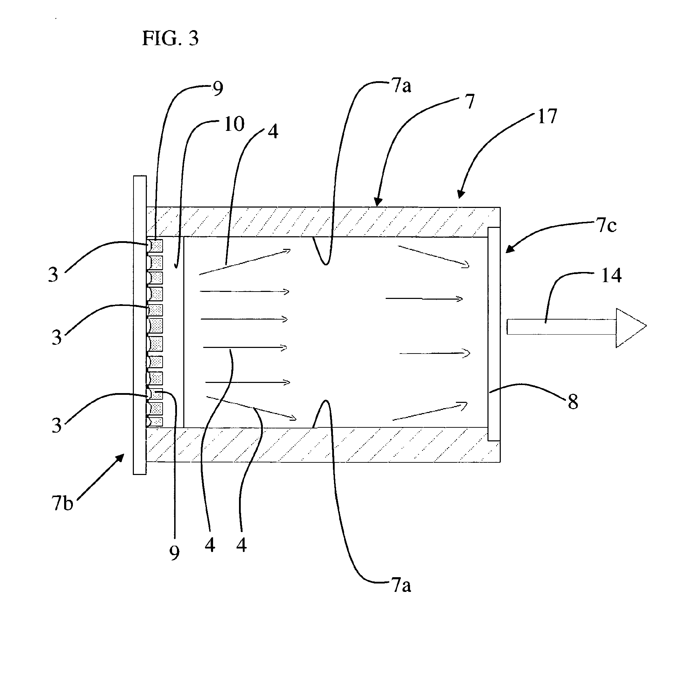

In a first embodiment, illustrated in figure 3, the box-like body 7 substantially has the shape of a cylinder. The LED light sources 3 are housed at a first base 7b of the cylinder 7. The optical element 8 is located at a second base 7c of the cylinder 7, placed opposite the reflecting surface 2. In the case of the cylindrical body 7, the interior walls 7a coincide with the interior lateral surface of the cylinder 7.

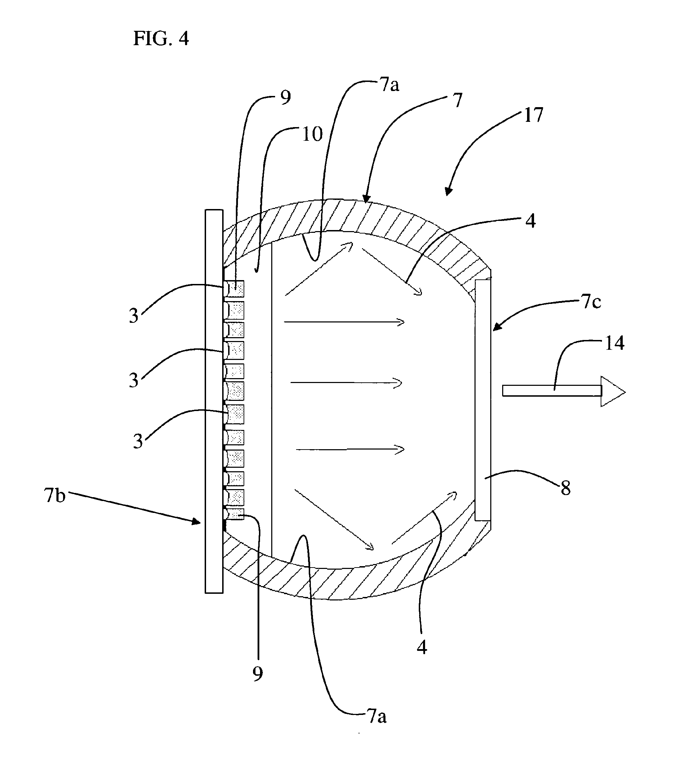

In a second embodiment, illustrated in figure 4, the box-like body 7 has outwardly-rounded interior walls 7a so as to favour the convergence of the light beams 4 issued by the sources 3 toward the optical element 8.

In the terminology used in the present description, by pre-established distance d is meant the distance of the optical element 8 from the centre of curvature of the parabolic or spherical reflecting surface 2.

The light sources 3 are regularly disposed on the first base 7b in such a way as to form a circular light support having a diameter which is smaller than or equal to the height of the box-like body 7.

A layer 10 of resin is arranged such as to cover the sources 3.

In the embodiments described and illustrated herein, the projector 1 comprises a plurality of lenses 9, each of which is operatively active upon a corresponding LED light source 3 so as to condition the emitted light beam 4.

Both the light sources 3 and the lenses 9 are preferably immersed in a layer 10 of resin.

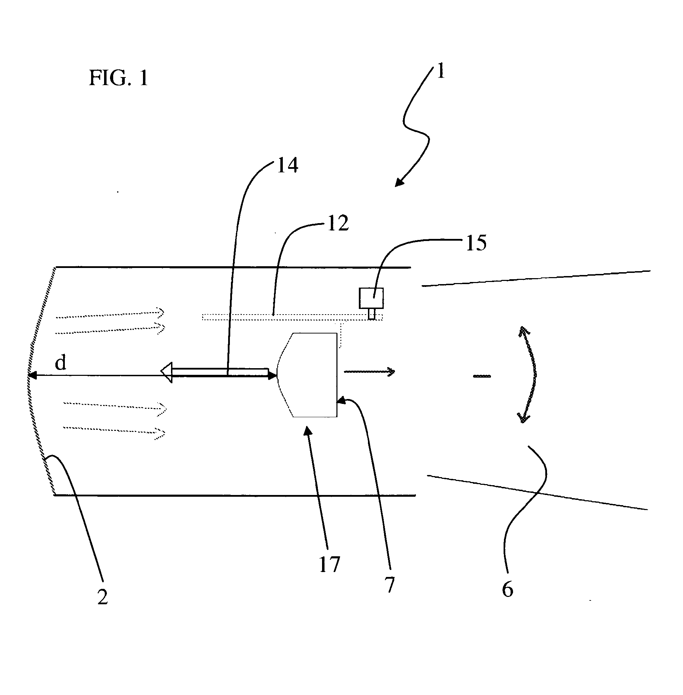

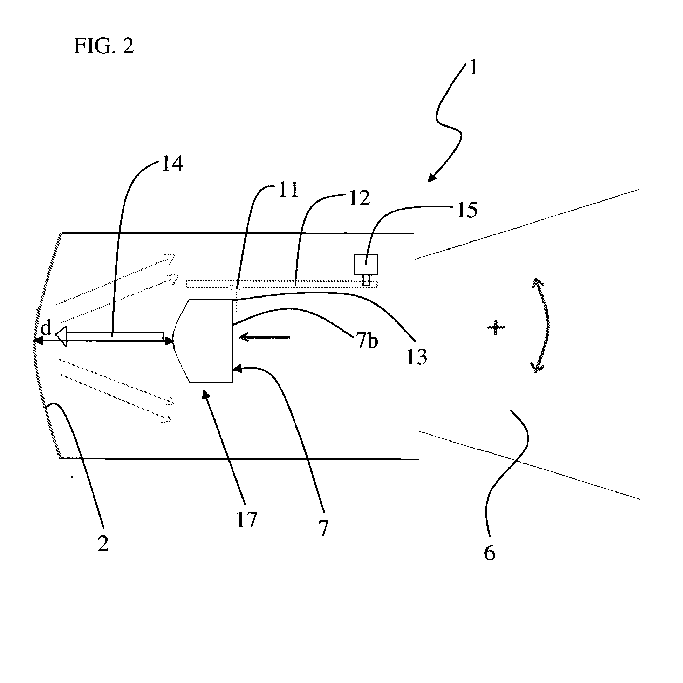

The box-like body 7 is preferably provided with a slide 11 designed to slide on a guide 12 extending substantially parallel to the main optical axis of the reflecting surface 2. In particular, the slide 11 and the guide 12 constitute means for varying the pred-established distance d. For example, as illustrated in figures 1 and 2, the box-like body 7 is provided with a support 13, positioned at a first base 7b thereof, on which the slide 11 slidable on the guide 12 is fashioned. The sliding of the slide 11 on the guide 12 can be performed manually or by means of motorised activation. Figures 1 and 2 schematically illustrate a motor 15 for activating the sliding of the slide 11 along the guide 12.

The functioning of the LED light projector is described in the following.

The LED light sources 3 emit light beams 4 which are reflected by the white-painted interior walls 7a of the box-like body 7 such as to become mixed. In particular, the mixing of the light beams 4 emitted by sources 3 is completed by the passage thereof through the lenses 9, the layer 10 of resin and the frosted lens 8. A single beam 14 thus exits from the box-like body 7 which, as it is incident on the reflecting surface 2, is reflected in a plurality of directions and generates the homogeneous light cone 6. To broaden the opening of the light cone 6, the box-like body 7 is moved by sliding the slide 11 on the guide 12 in a nearing direction to the reflecting surface 2. On the contrary, to narrow the aperture of the light cone 6, the box-like body 7 is moved by sliding the slide 11 on the guide 12 in a distancing direction from the reflecting surface 2.

From the above description the characteristics of the LED light projector of the invention emerge clearly, as do the advantages.

In particular, thanks to the use of the reflecting surface, the light emitted by the LED light sources can be indirectly exploited, thus achieving a uniform mixing of the mixed light beam originating from the box-like body. An observer located frontally of the projector cannot establish the type of the light source, but perceives a homogeneous illumination. In particular, the light sources are not visible to the observer.

Further, thanks to the use of white paints based on calcium carbonate or magnesium carbonate, which have a high diffusive capacity, an optimal mixture of the light beams emitted by the sources can be obtained.

The mixing of the beams is particularly appreciated in the theatre sector, as when projecting a shape on a background flat (at the cone side) a profile of the shadow is obtained that has a defined perimeter, which obviates the problems associated with multiplication of the shadows obtained with a traditional-type projection. Further, the structure of the box-like body contributes significantly to the uniformity of the mix, in which the box-like body, the lenses, the layer of resin and the frosted lens complete the mixing which has already been performed by the white-painted internal walls. For example, the cylindrical realisation enables less light dispersion to be obtained, while the realisation with outwardly-rounded walls enables the mixing to be further optimised.

Further, the aperture of the light cone generated by the projector is modifiable simply by moving the cylindrical body housing the light sources either towards or away from the reflecting surface.

Finally, the realising of a compact box-like body, destined to mix the various beams such as to obtain a single beam in outlet, enables the dimensions of the box-like body to be notably reduced with respect to the prior-art projectors.

## Claims

1. A LED light projector (1), comprising:
a plurality of LED light sources (3) capable of emitting a corresponding number of light beams (4);
means (17) for mixing the light beams (4) originating from the LED light sources (3) in such a way as to obtain a single beam (14), said means (17) comprising an optical element (8) located opposite said light sources (3), said optical element (8) being a frosted optical lens obtained from an assembly of optical micro-lenses;
a box-like body (7) housing within it said light sources (3), said box-like body (7) having interior walls (7a) painted white which form part of the means (17) for mixing the light beams (4) issued by the sources (3),
said LED light sources (3) being housed at a first base (7b) of the box-like body (7);
at least one reflecting surface (2) set at a pre-established distance (d) from said optical element (8) so that said single beam (14) exiting from the box-like body (7) strikes the reflecting surface (2), giving rise by reflection to a homogeneous light cone (6), said pre-established distance (d) being variable so as to modify the aperture of said light cone (6), said optical element (8) being located at a second base (7c) of the box-like body (7), **characterised in that** said second base (7c) is placed opposite the reflecting surface (2).

2. Projector according to claim 1, wherein said interior walls (7a) are coated with compounds based on calcium carbonate or magnesium carbonate in order to achieve a high diffusion power.

3. Projector (1) according to claim 1 or 2, wherein said box-like body (7) substantially has the shape of a cylinder having a first base (7b), where said LED light sources (3) are housed, and a second base (7c), located opposite the reflecting surface (2), where said optical element (8) is disposed, said interior walls (7a) coinciding with the interior lateral surface of said cylinder (7).

4. Projector (1) according to claim 1 or 2, wherein said box-like body (7) has:
a first base (7b), where said LED light sources (3) are housed;
a second base (7c), located opposite the reflecting surface (2), where said optical element (8) is disposed;
interior walls (7a) that are outwardly rounded so as to favour the convergence of the light beams (4) issued by the sources (3) toward the optical element (8).

5. Projector (1) according to claim 3 or 4, wherein the light sources (3) are regularly disposed on said first base (7b) in such a way as to form a circular light support having a diameter smaller than or equal to the height of said box-like body (7).

6. Projector (1) according to one of claims from 1 to 5, wherein said box-like body (7) is provided with a slide (11) designed to slide on a guide (12) extending substantially parallel to the main optical axis of said reflecting surface (2), said slide (11) and said guide (12) forming means for varying said pre-established distance (d).

7. Projector (1) according to any one of the preceding claims, further comprising a layer (10) of resin applied as covering for said LED light sources (3).

8. Projector (1) according to any one of claims from 1 to 6, further comprising a plurality of lenses (9), each of which is operatively active upon the corresponding LED light source (3) so as to condition the emitted light beam (4).

9. Projector according to claim 8, further comprising a layer (10) of resin applied as covering for the LED light sources (3), said lenses (9) being immersed in the layer (10) of resin.

10. Projector (1) according to claim 1, wherein said interior walls (7a) are coated with compounds based on titanium in order to achieve a high diffusion power.

11. Projector (1) according to any one of the preceding claims, wherein said reflecting surface (2) is parabolic or spherical.

## Patentansprüche

1. LED-Scheinwerfer (1), umfassend:
eine Vielzahl an LED-Lichtquellen (3), die eine entsprechende Anzahl von Lichtstrahlen (4) emittieren können;
Mittel (17) zum Mischen der Lichtstrahlen (4), die so von den LED-Lichtquellen (3) ausgehen, dass ein einzelner Strahl (14) erhalten wird, wobei die Mittel (17) ein optisches Element (8) umfassen, welches gegenüber den Lichtquellen (3) liegt, wobei das optische Element (8) eine mattierte optische Linse aus einer Anordnung von optischen Mikrolinsen ist;
einen kastenförmigen Körper (7), in welchem die Lichtquellen (3) untergebracht sind, wobei der kastenförmige Körper (7) weiß lackierte Innenwände (7a) aufweist, welche einen Teil der Mittel (17) zum Mischen der von den Quellen (3) abgegebenen Lichtstrahlen (4) bilden, wobei die LED-Lichtquellen (3) an einer ersten Basis (7b) des kastenförmigen Körpers (7) untergebracht sind,
mindestens eine reflektierende Oberfläche (2), die bei einem voreingestellten Abstand (d) vom optischen Element (8) liegt, so dass der aus dem kastenförmigen Körper (7) austretende einzelne Strahl (14) auf die reflektierende Oberfläche (2) trifft, woraus eine Reflexion zu einem homogenen Lichtkegel (6) entsteht,
wobei der voreingestellte Abstand (d) variabel ist, um so die Öffnung des Lichtkegels (6) zu modifizieren,
wobei das optische Element (8) an einer zweiten Basis (7c) des kastenförmigen Körpers (7) liegt, **dadurch gekennzeichnet, dass** sich die zweite Basis (7c) gegenüber der reflektierenden Oberfläche (2) befindet.

2. Projektor nach Anspruch 1, wobei die Innenwände (7a) mit auf Calciumcarbonat oder Magnesiumcarbonat basierenden Verbindungen beschichtet sind, um ein höheres Diffusionsvermögen zu erzielen.

3. Projektor (1) nach Anspruch 1 oder 2, wobei der kastenförmige Körper (7) im Wesentlichen die Form eines Zylinders aufweist, aufweisend eine erste Basis (7b), an der die LED-Lichtquellen (3) untergebracht sind, und eine zweite Basis (7c), die gegenüber der reflektierenden Oberfläche (2) liegt, an der das optische Element (8) angeordnet ist, wobei die Innenwände (7a) mit der inneren Seitenfläche des Zylinders (7) zusammenfallen.

4. Projektor (1) nach Anspruch 1 oder 2, wobei der kastenförmige Körper (7) Folgendes aufweist:
eine erste Basis (7b), an der die LED-Lichtquellen (3) untergebracht sind;
eine zweite Basis (7c), welche gegenüber der reflektierenden Oberfläche (2) liegt, an der das optische Element (8) angeordnet ist;
Innenwände (7a), die nach außen abgerundet sind, so dass die Konvergenz der Lichtstrahlen (4), welche von den Quellen (3) zum optischen Element (8) ausgegeben werden, begünstigt wird.

5. Projektor (1) nach Anspruch 3 oder 4, wobei die Lichtquellen (3) regelmäßig an der ersten Basis (7b) so angeordnet sind, dass sie eine kreisförmige Lichtunterstützung, aufweisend einen Durchmesser, der kleiner oder gleich der Höhe des kastenförmigen Körpers (7) ist, bilden.

6. Projektor (1) nach Anspruch 1 bis 5, wobei der kastenförmige Körper (7) mit einem Schlitten (11) ausgestattet ist, der dazu konzipiert ist, auf einer Führung (12), die sich im Wesentlichen parallel zur optischen Hauptachse der reflektierenden Oberfläche (2) erstreckt, zu gleiten, wobei der Schlitten (11) und die Führung (12) Mittel zur Änderung des voreingestellten Abstands (d) bilden.

7. Projektor (1) nach einem der vorangehenden Ansprüche, ferner umfassend eine Schicht (10) aus Harz, welche als Überzug der LED-Lichtquellen (3) aufgetragen ist.

8. Projektor (1) nach einem der Ansprüche 1 bis 6, ferner umfassend eine Vielzahl an Linsen (9), von denen jede auf die entsprechenden LED-Lichtquellen (3) betriebswirksam einwirkt, um den emittierten Lichtstrahl (4) zu konditionieren.

9. Projektor nach Anspruch 8, ferner umfassend eine Schicht (10) aus Harz, die als Überzug der LED-Lichtquellen (3) aufgetragen ist, wobei die Linsen (9) in die Harzschicht (10) eingetaucht sind.

10. Projektor (1) nach Anspruch 1, wobei die Innenwände (7a) mit auf Titan basierenden Verbindungen beschichtet sind, um ein höheres Diffusionsvermögen zu erzielen.

11. Projektor (1) nach einem der vorangehenden Ansprüche, wobei die reflektierende Oberfläche (2) parabolisch oder kugelförmig ist.

## Revendications

1. Projecteur à DEL (1), comprenant :
une pluralité de sources DEL (3) aptes à émettre un nombre correspondant de faisceaux lumineux (4) ;
des moyens (17) pour mélanger les faisceaux lumineux (4) provenant des sources DEL (3) de sorte à obtenir un faisceau unique (14), lesdits moyens (17) comprenant un élément optique (8) situé à l'opposé desdites sources lumineuses (3), ledit élément optique (8) étant une lentille optique dépolie obtenue à partir de l'assemblage de micro lentilles optiques ;
un corps en forme de boîte (7) logeant en son sein lesdites sources lumineuses (3), ledit corps en forme de boîte (7) comprenant des parois internes (7a) peintes en blanc faisant partie des moyens (17) pour mélanger les faisceaux lumineux (4) générés par les sources (3), lesdites sources DEL (3) étant logées sur une première base (7b) du corps en forme de boîte (7) ;
au moins une surface réflectrice (2) placée à une distance préétablie (d) à partir dudit élément optique (8) de sorte que le faisceau unique (14) sortant du corps en forme de boîte (7) frappe la surface réflectrice (2), donnant naissance par réflexion à un cône de lumière homogène (6), ladite distance préétablie (d) étant variable de sorte à modifier l'ouverture dudit cône de lumière (6), ledit élément optique (8) étant situé sur une seconde base (7c) du corps en forme de boîte (7), **caractérisé en ce que** ladite seconde base (7c) est placée à l'opposé de la surface réflectrice (2).

2. Projecteur selon la revendication 1, dans lequel lesdites parois internes (7a) sont recouvertes de composés à base de carbonate de calcium ou de carbonate de magnésium afin d'atteindre une puissance de diffusion élevée.

3. Projecteur (1) selon les revendications 1 ou 2, dans lequel ledit corps en forme de boîte (7) a substantiellement la forme d'un cylindre possédant une première base (7b), où sont logées lesdites sources DEL (3), et une seconde base (7c), située à l'opposé de la surface réflectrice (2), où est disposé ledit élément optique (8), lesdites parois internes (7a) coïncidant avec la surface latérale interne dudit cylindre (7).

4. Projecteur (1) selon les revendications 1 ou 2, dans lequel le corps en forme de boîte (7) comporte :
une première base (7b), où sont logées les sources DEL (3) ;
une seconde base (7c), située à l'opposé de la surface réflectrice (2), où est disposé ledit élément optique (8) ;
des parois internes (7a) étant arrondies à l'extérieur de sorte à favoriser la convergence des faisceaux lumineux (4) générés par les sources (3) vers l'élément optique (8).

5. Projecteur (1) selon les revendications 3 ou 4, dans lequel les sources lumineuses (3) sont régulièrement disposées sur ladite première base (7b) de sorte à former un support de lumière circulaire ayant un diamètre inférieur ou égal à la hauteur dudit corps en forme de boîte (7).

6. Projecteur (1) selon l'une des revendications de 1 à 5, dans lequel ledit corps en forme de boîte (7) est doté d'une glissière (11) conçue pour coulisser sur un guide (12) se développant substantiellement de façon parallèle à l'axe optique principal de ladite surface réflectrice (2), ladite glissière (11) et ledit guide (12) formant les moyens pour modifier ladite distance préétablie (d).

7. Projecteur (1) selon l'une quelconque des revendications précédentes, comprenant de plus une couche (10) de résine appliquée pour recouvrir lesdites sources DEL (3).

8. Projecteur (1) selon l'une des revendications de 1 à 6, comprenant de plus une pluralité de lentilles (9), chacune étant opérationnellement active sur la source DEL correspondante (3) de sorte à conditionner le faisceau lumineux émis (4).

9. Projecteur selon la revendication 8, comprenant de plus une couche (10) de résine appliquée pour recouvrir lesdites sources DEL (3), lesdites lentilles (9) étant immergées dans la couche (10) de résine.

10. Projecteur (1) selon la revendication 1, dans lequel lesdites parois internes (7a) sont recouvertes de composés à base de titane afin d'atteindre une puissance de diffusion élevée.

11. Projecteur (1) selon l'une quelconque des revendications précédentes, dans lequel ladite surface réflectrice (2) est parabolique ou sphérique.
